# EUROPEAN PATENT APPLICATION

(11) **EP 1 463 073 A1**
(43) Date of publication of application: **29.09.2004**
(21) Application number: 03006593.2
(22) Date of filing: 24.03.2003
(51) Int. Cl.: H01G 9/20, H01L 31/052, H01L 31/036

(54) **Porous film having a gradient of light scattering strength**

(71) Applicant: Sony International (Europe) GmbH, 10785 Berlin (DE)
(72) Inventor: Dürr, Michael, Sony International (Europe) GmbH, 70327 Stuttgart (DE); Nelles, Gabriele, Sony International (Europe) GmbH, 70327 Stuttgart (DE); Yasuda, Akio, Sony International (Europe) GmbH, 70327 Stuttgart (DE)
(74) Representative: Appelt, Christian W.

(57) **Abstract**

The invention relates to a porous film for use in an electronic device, uses of such a porous film, a method of producing a porous film and a porous film produced by said method, whereby the porous film has a gradient of light scattering strength.

## Description

The invention relates to a porous film for use in an electronic device, uses of such a porous film, a method of producing a porous film and a porous film produced by said method.

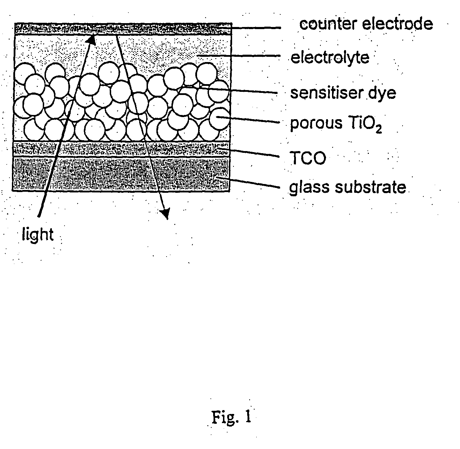

Single crystal solar cells show energy conversion efficiencies as high as ∼ 25%. Where the Si-based crystals are no longer single crystals but polycrystalline, the highest efficiencies are in the range of ∼18%, and with amorphous Si the efficiencies are ∼12%. Solar cells based on Si are, however, rather expensive to manufacture, even in the amorphous Si version. Therefore alternatives have been developed based on organic compounds and/or a mixture of organic and inorganic compounds, the latter type solar cells often being referred to as hybrid solar cells. Organic and hybrid solar cells have proved to be cheaper to manufacture, but seem to have yet comparably low efficiencies even when compared to amorphous Si cells. Due to their inherent advantages such as lightweight, low-cost fabrication of large areas, earth-friendly materials, or preparation on flexible substrates, efficient organic devices might prove to be technically and commercially useful 'plastic solar cells'. Recent progress in solar cells based on dye-sensitised nanocrystalline titanium dioxide (porous TiO₂) semiconductor and a liquid redox electrolyte demonstrates the possibility of high energy conversion efficiencies in organic materials [B. O'Regan and M. Gratzel, Nature 353 (1991) 737. The basic structure of such a hybrid solar cell is illustrated in figure 1.

Photoelectochemical cells based on sensitisation of nanocrystalline TiO₂ by molecular dyes (dye sensitised solar cells, DSSC) have attracted great attention since their first announcement as efficient photovoltaic devices (B. O'Regan and M. Grätzel, ibid.; W0 91/16719). One thrust of investigations to increase the efficiency of this type of solar cells has been the improvement of light guidance in the device to increase the optical pathlength and therefore enhance the light absorption capability at a given thickness of the active layer of the device. To do so, enhanced light scattering within the active layer has been the subject of several publications.

The reported efforts on DSSCs can be classified as follows:
Various authors have considered to increase the overall scattering ability of the nanocrystalline TiO₂ layer by an increase of particle size and/or admixture of particle with larger diameter. ([1] C. B. Barbé et al., J. Am. Ceram. Soc. **80**, 3157 (1997); [2] G. Rothenberger, P. Comte, and M. Grätzel, Solar Energy Materials & Solar Cells **58**, 321 (1999); [3] A Usami, Solar Energy Materials & Solar Cells **62**, 239 (2000); [4] A Usami, Solar Energy Materials & Solar Cells **64**, 73 (2000))
Others have made theoretical considerations on two layer systems with different light scattering abilities of the different layers. ([5] A Usami, Chemical Physics Letters **277**, 105 (1997); [6] J. Ferber and J. Luther, Solar Energy Materials and Solar Cells **54**, 265 (1998))
Furthermore layers with enhanced scattering have also been proposed for an improved efficiency of thin film crystalline silicon solar cells. ([7] J. Bruns et al., Applied Physics Letters **64**, 2700 (1994); [8] V. A Skryshevsky and A Laugier, Thin Solid Films **346**, 261 (1999))

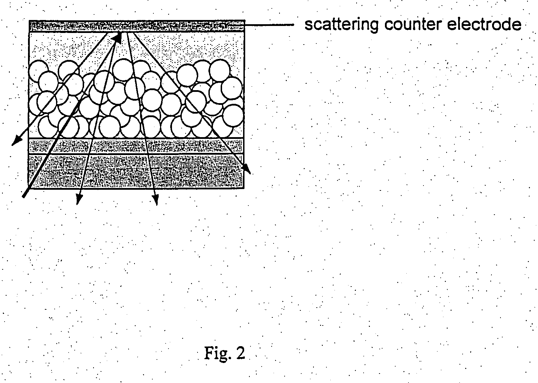

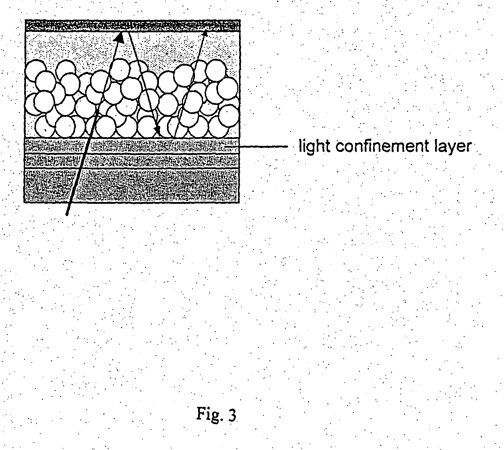

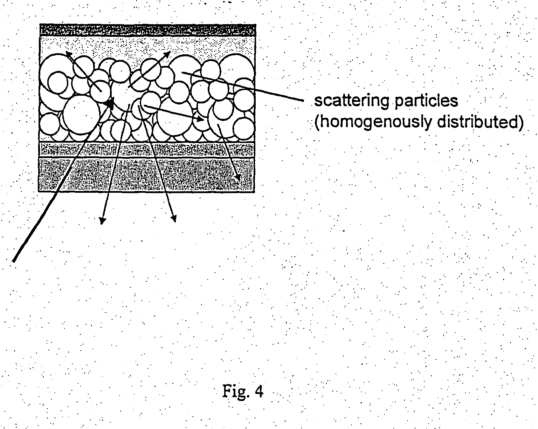

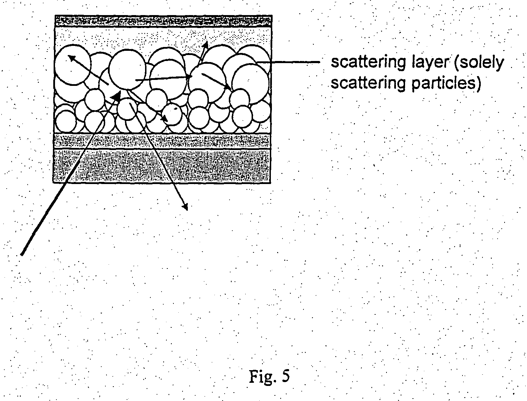

The disadvantages of the state of the art cells can be listed as follows:
(1) A standard DSSC is depicted in Fig. 1. It consists of a substrate (glass), a transparent conductive oxide layer, a porous TiO₂ layer (non-scattering) with electrolyte, an electrolyte layer, and counter electrode (platinum). The light path goes as depicted, i.e. in the best case it is reflected at the counter electrode and passes twice the porous layer.
   The disadvantages associated therewith are:
   (i) The light path through the porous layer is short. After a length of two times the thickness of the porous layer, the light is lost.
   (ii) Before and after being reflected at the back electrode, light is partly absorbed by the electrolyte.
   (iii)The absorption can only be increased by thicker porous layers. This is of disadvantage with respect to mechanical stability and electrolyte transport properties in the porous layer if it can be realized at all. In general, thin layers are preferable.
(2) A standard DSSC which additionally has a scattering counter electrode is shown in Fig. 2.
   The disadvantages associated with such an arrangement are:
   (i) The light path through the porous layer is short.
   (ii) Before and after being reflected at the back electrode, light is partly absorbed by the electrolyte.
(3) A standard DSSC as in (1) or (2), above, which additionally performs light confinement by reflection at the front electrode is shown in Fig. 3, see also, e.g., Ref.[4].
   The disadvantages associated therewith are:
   (i) Although the length of the light path is (advantageously) increased in the active layer, this is also the case in the electrolyte which means that the light absorbed there is lost.
   (ii) An additional layer/process for the front electrode is necessary
(4) A standard DSSC with a light scattering porous layer having a constant scattering strength over the whole layer is shown in Fig. 4; see also, e.g., Barbé et al., ibid.
   The disadvantage associated therewith is:
   (i) A relative high amount of light is scattered back from the porous layer without absorption.
(5) A standard DSSC with two nanocrystalline TiO₂ layers, the first one being transparent, the second one consisting of bigger particles as proposed in [5] and [6], see above, is shown in Fig. 5.
   The disadvantage associated therewith is:
   (i) The bigger particles exhibit a lower specific surface area and therefore less amount of dye is attached. Light scattered within this layer is more likely to be absorbed by the electrolyte than by the dye molecules. There is hardly any absorbance in the light-scattering layer.
   (ii) Light scattered back to transparent layer has non-zero probability to be not absorbed.
(6) A combination of (3) and (5).
   The disadvantages associated therewith are:
   (i) The bigger particles exhibit a lower specific surface area and therefore less amount of dye is attached. Light scattered within this layer is more likely to be absorbed by the electrolyte than by the dye molecules.
   (ii) An additional layer / process for the front electrode necessary

As an explanatory note to the above, it has to be said that:
(a) The ratio of thickness to cover-area of the DSSC is very small, which means that losses at the sides of the DSSC can be neglected.
(b) The schemes of (5) and (6) have not been realised yet since there hasn't been a method to fabricate such structures (compare, e.g., Ref.[2], see above).

Accordingly it has been an object of the present invention to avoid the aforementioned problems associated with the prior art. It has furthermore been an object of the present invention to increase the efficiency of photovoltaic devices. Furthermore it has been an object of the present invention to provide for a better light management in photovoltaic devices.

All these objects are solved by a porous film for use in an electronic device, in particular a solar cell, said film having a front face and a back face, characterized in that said porous film has a gradient of light scattering strength extending from said front face to said back face, with the light scattering strength increasing towards said back face.

In one embodiment, said gradient of light scattering strength starts with zero light scattering at said front face.

In one embodiment, said porous film comprises at least two layers, each layer having a first kind of particles of one average diameter or length and one layer having additionally a second kind of particles having a larger average diameter or length, wherein, preferably, said porous film comprises at least three layers, each layer having a first kind of particles of one average diameter or length, and at least one layer having additionally at least a second kind of particles having a larger average diameter or length. In one embodiment, said at least one second kind of particles are light-scattering particles.

The term "a layer having additionally a second kind of particles" is meant to signify that in addition to a first kind of particles there is a second kind of particles present in the layer.

More preferably, said porous film comprises a plurality of layers, each layer having a first kind of particles of one average diameter or length, and at least one layer having additionally at least a second kind of particles having a larger average diameter or length.

In one embodiment, said particles have a shape selected from the group comprising rods, tubes, cylinders, cubes, parallelipeds, spheres, balls and ellipsoids, wherein, preferably, said particles are selected from the group comprising semi-conducting material particles, metal particles and insulating particles.

Preferably, the semi-conducting material particles are selected from the group comprising TiO₂-particles, ZnO-particles, SnO-particles, Sb₂O₅-particle CdTe-particles, CdSe-particles and CdS-particles.
"Insulating particles", as used herein, are particles which are electrically non-conducting.

In one embodiment, the at least two layers/three layers/plurality of layers have been applied subsequently, wherein, preferably, the at least two/three/plurality of layers have been applied subsequently by a technique selected from the group comprising screen printing, doctor blading, drop casting, spin coating, sol gel process and lift-off techniques.

In one embodiment, the first kind of particles have an average diameter in the range of from 2 nm to 25 nm, preferably from 3 nm to 20 nm, or they have an average length of from 3 nm to 300 nm, preferably from 10 nm to 100 nm.

In one embodiment, the second kind of particles have an average diameter or length in the range of from 50 nm to 1 µm, preferably from 100 nm to 500 nm, more preferably from 200 nm to 400 nm.

In one embodiment, in the layer(s) having additionally a second kind of particles, the ratio of the first kind of particles to the second kind of particles is in the range of from 10:1 to 1:1, preferably from 8:1 to 2:1, wherein, preferably, the ratio is a weight ratio.

In another embodiment, the ratio is a volume ratio.

In one embodiment, the porous film comprises a plurality of layers, each layer having a first kind of particles of one average diameter or length, and all but one layer having a second kind of particles, wherein in each of the layers having a second kind of particles, either
(i) the average diameter or length of the second kind of particles is the same in each layer and the amount of the second kind of particles present in each layer varies from layer to layer,
   or
(ii) the amount of the second kind of particles present in each layer is the same in each layer and the average diameter or length of the second kind of particles varies from layer to layer.

Preferably, where the amount of the second kind of particles present in each layer varies from layer to layer, it increases from layer to layer, and where the average diameter or length of the second kind of particles present in each layer varies from layer to layer, it increases from layer to layer.

In one embodiment, the one layer having only a first kind of particles is closer to said front face of said porous film than to said back face, wherein, preferably, said one layer having only a first kind of particle is adjacent to said front face.

In one embodiment, the (at least) one layer having additionally (at least) a second kind of particles both absorbs and scatters light, whereby, preferably, the light absorption does not differ substantially from that of the other layer(s), and whereby, more preferably, the light absorption in the whole porous film is nearly constant.

In one embodiment, all layers in the porous film according to the present invention have been treated with a dye.

Preferably, the porous film according to the present invention is dye-sensitised.

In one embodiment, each layer contains at least one type of dye, wherein, preferably, the dye molecules coat the first and second kind of particles (and, if present, the third, fourth, etc ... kind of particles).

The objects of the present invention are also solved by the use of a porous film according to the present invention in an electronic device, in particular a solar cell.

They are also solved by an electronic device comprising a porous film according to the present invention.

Preferably, the electronic device is a solar cell.

In one embodiment, the solar cell comprises a reflective back electrode.

In one embodiment, the solar cell comprises a light confinement layer.

As used herein, a "light confinement layer" is a layer which allows to increase the light pathlength within a solar cell, e.g. by reflection.

In one embodiment, the solar cell comprises an electrolyte, wherein, preferably, the electrolyte is selected from the group comprising liquid electrolytes, polymer gel electrolytes and solid state electrolytes.

The objects of the present invention are also solved by a method of forming a porous film having a gradient of light scattering strength across its thickness, comprising the steps:
a) providing a first kind of particles having one average diameter or length,
b) providing a second kind of particles,
c) providing a substrate,
d) applying onto said substrate a plurality of layers, each layer having said first kind of particles of one average diameter or length, and all but one layer having said second kind of particles, wherein in each of said layers having a second kind of particles, either
   (i) the average diameter or length of said second kind of particles is the same in each layer and the amount of said second kind of particles present in each layer varies from layer to layer,
      or
   (ii) the amount of said second kind of particles present in each layer is the same in each layer and the average diameter or length of said second kind of particles varies from layer to layer.

Preferably, where the amount of said second kind of particles present in each layer varies from layer to layer, said amount increases from layer to layer, and, where said average diameter or length of said second kind of particles present in each layer varies from layer to layer, said average diameter or length increases from layer to layer.

In one embodiment, steps a), b) and c) can be in any order.

In one embodiment, the application of said plurality of layers occurs by a technique selected from the group comprising screen printing, doctor blading, drop casting, spin coating, sol gel process, and lift-off techniques and any combination of the aforementioned techniques, wherein, preferably, each layer is applied separately.

As used herein, the term "lift-off technique" is meant to designate any technique whereby a transfer of layer(s) occurs from one surface to another surface.

In one embodiment, after application of a layer there is a drying step.

In one embodiment, the porous film is sintered after all layers have been applied.

The objects of the present invention are furthermore solved by a porous film produced by the method according to any of the present invention.

They are also solved by a use of a porous film produced by the method according to the present invention in an electronic device, in particular a solar cell.

They are furthermore solved by an electronic device comprising a porous film according to the present invention.

Preferably, the electronic device is a solar cell.

In one embodiment, the solar cell comprises a reflective back electrode.

In one embodiment, the solar cell comprises a light confinement layer.

In one embodiment, the solar cell comprises an electrolyte.

As used herein, a "gradient of light scattering strength extending from the front face to the back face, with the light scattering strength increasing towards the back face" can be a continuous gradient or a discontinuous gradient with a stepwise increase of light scattering strength, or a combination of both possibilities. In a preferred embodiment the gradient comprises at least two, preferably three, preferably more than three, most preferably at least four different light scattering strengths, which preferably coincide with the number of layers present in the porous film according to the present invention.

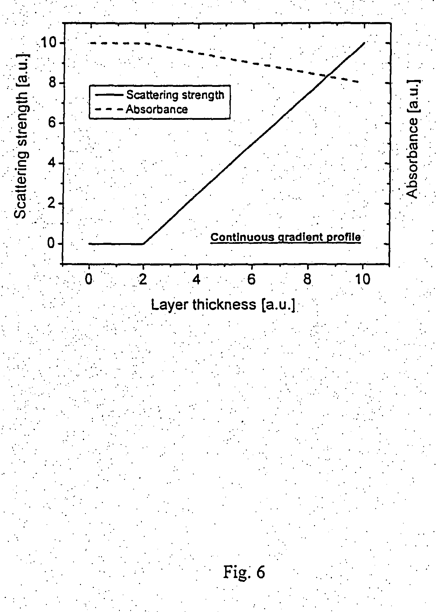

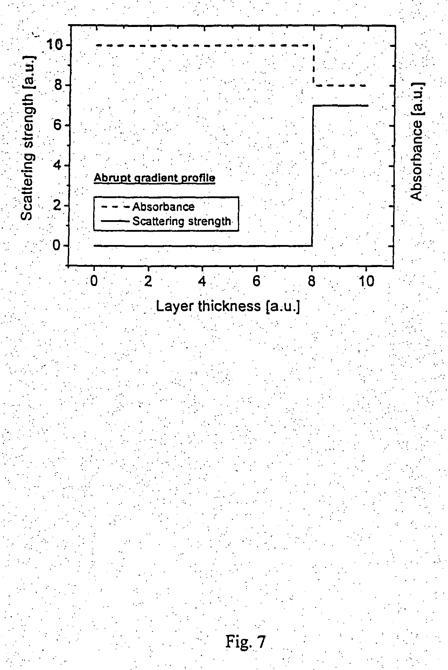

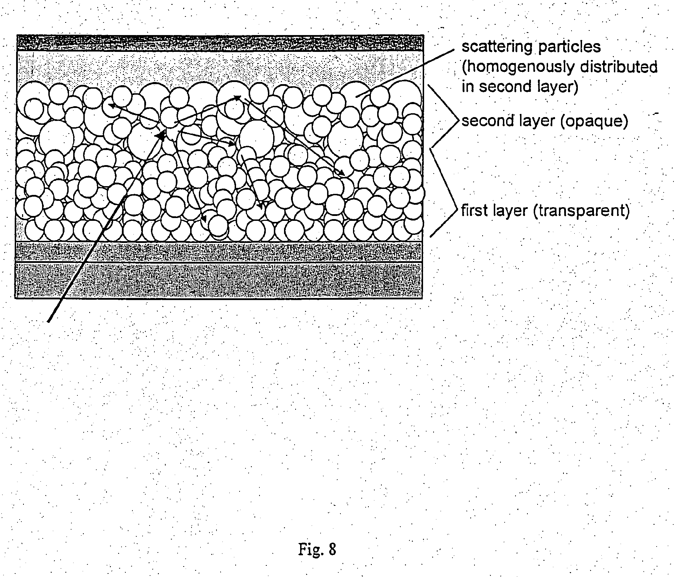

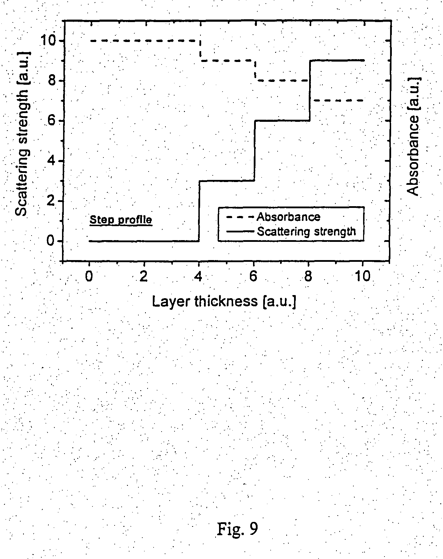

The inventors have surprisingly found that the above listed disadvantages can be overcome by application of a porous film with a gradient of scattering strength (SS) starting with a SS = 0 at the front electrode and increasing SS towards the back electrode with nearly constant absorbance throughout the whole film (Fig. 6). The simplest realisation is an abrupt gradient between two layers with different scattering strength, i.e. one thicker transparent layer and one thinner scattering layer (Fig. 7). The increased SS is realised by admixing highly scattering particles of larger average diameter or average length (preferably several hundred nanometers) to a majority of small particles (preferably 3-20 nm in average diameter, or 10-100 nm in average length), both, in the thinner scattering layer as well as in the continuous profile of scattering strength. The particles can adopt a great variety of shapes, e.g. balls spheres, rods, parallelipeds etc. as outlined above. In the two-layer system, the abrupt gradient can be achieved by subsequent application of screen printing with two different porous TiO₂ materials of SS as described above (Fig. 8). A more sophisticated profile (i.e. closer to a continuous gradient profile) can be achieved by the multiple subsequent application of screen printing with different porous TiO₂ materials, respectively (Fig. 9). Other layer by layer techniques than screen printing, which are known to someone skilled in the art, e. g. doctor blading, drop casting, spin coating, sol gel process, lift-off techniques, and any combination of the aforementioned techniques can be applied to form a porous film according to the present invention.

The inventors have also surprisingly found that by application of a gradient of scattering strength within the electron transport layer, e.g . a nanocrystalline TiO₂ layer, of an electronic device, e.g. a solar cell, a high absorbance throughout the whole electron transport layer, i.e. in the non-scattering parts as well as in the scattering parts, which absorbance is nearly constant, can be achieved.

As a result, a high efficiency DSSC
- with long optical path length
- with minimised backscattering from the porous layer through optimised SS gradient profile
- with a light path without multiple crossing of the electrolyte
- without additional reflection layer at the front electrode
- with absorption in the whole porous layer,
can be produced.

Reference is now made to the figures, wherein
figure 1 shows a standard dye-sensitized solar cell,
figure 2 shows a standard dye-sensitized solar cell, additionally having a scattering counter electrode,
figure 3 shows a standard dye-sensitized solar cell, additionally performing light confinement by reflection at the front electrode,
figure 4 shows a standard dye-sensitized solar cell having a light scattering porous layer with a constant scattering strength over the whole layer,
figure 5 shows a standard dye-sensitized solar cell having two nanocrystalline TiO₂-layers, i.e. one non-scattering, absorbing layer and one scattering, almost non-absorbing layer.
figure 6 shows an example of a continuous gradient profile of light scattering strength as envisioned by the present invention, with the scattering strength and absorbance plotted versus thickness of the porous film according to the present invention, layer thickness 0 in figure 6 denotes the front electrode,
figure 7 shows an example of a gradient profile with a discrete step of different light scattering strengths, wherein light scattering strength and absorbance are plotted versus thickness of the porous film according to present invention, layer thickness 0 in figure 7 denotes the front electrode,
figure 8 shows an example of a two layer system of the porous film according to present invention realising the gradient profile with a discrete step of different light scattering strengths,
figure 9 shows an example of a gradient with several discrete steps of different light scattering strengths, wherein light scattering strength and absorbance are plotted versus thickness of the porous film according to the present invention, and
figure 10 shows the I-V-characteristics of two cells with and without a gradient in scattering strength.
The invention will now be further described by means of the following example, which is given to illustrate, not to limit the present invention.

### Example

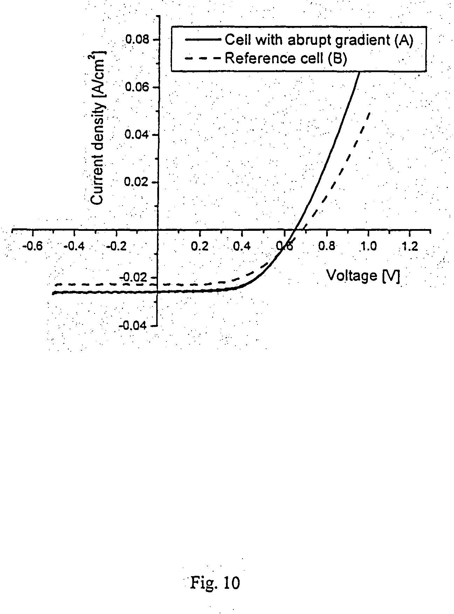

A comparison of two solar cells, A and B, with and without abrupt profile of SS, has shown a clear improvement in efficiency of the cell A with abrupt profile (power conversion efficiency at a light intensity of 100mW/cm² from a sulphur lamp: η = 9.7%) compared to the cell B with a constant SS over the whole porous layer (η = 8.1%). The current-voltage characteristics of these cells are shown in Fig. 10.

This prototype cell A consisted in detail of a glass substrate, a conductive FTO layer (approx. 100nm) with a bulk TiO₂ coating (approx. 30nm), a first porous TiO₂ layer of 9µm thickness, containing particles with average diameter of about 18nm and an average poresize of about 26nm followed by a second, highly scattering porous layer of 2µm thickness, consisting of a mixture of particles with average diameter of 18nm (80w%) and particles with average diameter of 300nm (20w%). Both porous layers were applied subsequently by screen printing with the first layer being dried at 80 degrees centigrade for half an hour before application of the second one. The double layer system was sintered at 450 degrees centigrade for half an hour after an additional drying at 80 degrees centigrade (0.5 h). Red dye molecules (N3 bis-TBA) are attached as monolayer to TiO₂ via self assembling out of a solution in ethanol (0.3mM). The coloured porous layer is filled with a polymer electrolyte (PEO in PC/EC) with iodine/iodide (0.015mM) serving as redox-couple. A 6µm thick bulk layer of the same polymer electrolyte bridges the gap between porous layer and a flat, smooth platinum back electrode.

The features of the present invention disclosed in the specification, the claims and/or in the accompanying drawings, may, both separately, and in any combination thereof, be material for realising the invention in various forms thereof.

## Claims

1. A porous film for use in an electronic device, in particular a solar cell, said film having a front face and a back face, **characterized in that** said porous film has a gradient of light scattering strength extending from said front face to said back face, with the light scattering strength increasing towards said back face.

2. The porous film according to claim 1, **characterized in that** said gradient of light scattering strength starts with zero light scattering at said front face.

3. The porous film according to any of claims 1 - 2, **characterized in that** said porous film comprises at least two layers, each layer having a first kind of particles of one average diameter or length and one layer having additionally a second kind of particles having a larger average diameter or length.

4. The porous film according to claim 3, **characterized in that** said porous film comprises at least three layers, each layer having a first kind of particles of one average diameter or length, and at least one layer having additionally at least a second kind of particles having a larger average diameter or length.

5. The porous film according to claim 4, **characterized in that** said porous film comprises a plurality of layers, each layer having a first kind of particles of one average diameter or length, and at least one layer having additionally at least a second kind of particles having a larger average diameter or length.

6. The porous film according to any of claims 3 - 5, **characterized in that** said particles have a shape selected from the group comprising rods, tubes, cylinders, cubes, parallelipeds, spheres, balls and ellipsoids.

7. The porous film according to any of claims 3 - 6, **characterized in that** said particles are selected from the group comprising semi-conducting material particles, metal particles and insulating particles.

8. The porous film according to any of claims 3 - 7, **characterized in that** the at least two layers/three layers/plurality of layers have been applied subsequently.

9. The porous film according to claim 8, **characterized in that** the at least two/three/plurality of layers have been applied subsequently by a technique selected from the group comprising screen printing, doctor blading, drop casting, spin coating, sol gel process and lift-off techniques, and any combination of the aforementioned techniques.

10. The porous film according to any of claims 3 - 9, **characterized in that** the first kind of particles have an average diameter in the range of from 2 nm to 25 nm, preferably from 3 nm to 20 nm, or they have an average length of from 3 nm to 300 nm, preferably from 10 nm to 100 nm.

11. The porous film according to any of claims 3 - 10, **characterized in that** the second kind of particles have an average diameter or length in the range of from 50 nm to 1 µm, preferably from 100 nm to 500 nm, more preferably from 200 nm to 400 nm.

12. The porous film according to any of claims 3 - 11, **characterized in that**, in the layer(s) having additionally a second kind of particles, the ratio of the first kind of particles to the second kind of particles is in the range of from 10:1 to 1:1, preferably from 8:1 to 2:1.

13. The porous film according to claim 12, **characterized in that** the ratio is a weight ratio.

14. The porous film according to claim 12, **characterized in that** the ratio is a volume ratio.

15. The porous film according to any of the foregoing claims, comprising a plurality of layers, each layer having a first kind of particles of one average diameter or length, and all but one layer having a second kind of particles, wherein in each of the layers having a second kind of particles,
either
(i) the average diameter or length of the second kind of particles is the same in each layer and the amount of the second kind of particles present in each layer varies from layer to layer,
or
(ii) the amount of the second kind of particles present in each layer is the same in each layer and the average diameter or length of the second kind of particles varies from layer to layer.

16. The porous film according to claim 15, **characterized in that**, where the amount of the second kind of particles present in each layer varies from layer to layer, it increases from layer to layer, and where the average diameter or length of the second kind of particles present in each layer varies from layer to layer, it increases from layer to layer.

17. The porous film according to any of claims 15 - 16, **characterized in that** the one layer having only a first kind of particles is closer to said front face of said porous film than to said back face.

18. The porous film according to claim 17, **characterized in that** said one layer having only a first kind of particle is adjacent to said front face.

19. Use of a porous film according to any of the foregoing claims in an electronic device, in particular a solar cell.

20. Electronic device comprising a porous film according to any of the claims 1 - 19.

21. Electronic device according to claim 20, which is a solar cell.

22. Solar cell according to claim 21, further comprising a reflective back electrode.

23. Solar cell according to any of claims 21 - 22, further comprising a light confinement layer.

24. Solar cell according to any of claims 21 - 23, further comprising an electrolyte.

25. A method of forming a porous film having a gradient of light scattering strength across its thickness, comprising the steps:
a) providing a first kind of particles having one average diameter or length,
b) providing a second kind of particles,
c) providing a substrate,
d) applying onto said substrate a plurality of layers, each layer having said first kind of particles of one average diameter or length, and all but one layer having said second kind of particles, wherein in each of said layers having a second kind of particles, either
(i) the average diameter or length of said second kind of particles is the same in each layer and the amount of said second kind of particles present in each layer varies from layer to layer,
or
(ii) the amount of said second kind of particles present in each layer is the same in each layer and the average diameter or length of said second kind of particles varies from layer to layer.

26. A method according to claim 25, **characterized in that**, where the amount of said second kind of particles present in each layer varies from layer to layer, said amount increases from layer to layer, and, where said average diameter or length of said second kind of particles present in each layer varies from layer to layer, said average diameter or length increases from layer to layer.

27. The method according to any of claims 25 - 26, **characterized in that** steps a), b) and c) can be in any order.

28. The method according to any of claims 25 - 27, **characterized in that** the application of said plurality of layers occurs by a technique selected from the group comprising screen printing, doctor blading, drop casting, spin coating, sol gel process, and lift-off techniques, and any combination of the aforementioned techniques.

29. The method according to any of claims 25 - 28, **characterized in that** each layer is applied separately.

30. The method according to claim 29, **characterized in that** after application of a layer there is a drying step.

31. The method according to any of claims 25 - 30, **characterized in that** the porous film is sintered after all layers have been applied.

32. A porous film produced by the method according to any of claims 25 - 31.

33. Use of a porous film according to claim 32 in an electronic device, in particular a solar cell.

34. An electronic device comprising a porous film according to claim 32.
